# EUROPEAN PATENT SPECIFICATION

(11) **EP 0 282 195 B1**
(45) Date of publication and mention of the grant of the patent: **13.04.1994**
(21) Application number: 88301513.3
(22) Date of filing: 23.02.1988
(51) Int. Cl.: G01S 7/40

(54) **Radar performance monitor**
Vorrichtung zur Überwachung der Radarleistungsfähigkeit
Dispositif de contrôle de la performance d'un radar

(30) Priority: 06.03.1987 US 23068
(43) Date of publication of application: 14.09.1988
(73) Proprietor: RAYTHEON COMPANY, Lexington Massachusetts 02173 (US)
(72) Inventor: Wilson, William J., Wenham Massachusetts 01984 (US); Lacey, Neil F., Framingham Massachusetts 01791 (US); Freedman, Nathan, W. Newton Massachusetts 02165 (US); Byington, Roy E., Sudbury Massachusetts 01776 (US); Armstrong, David G., Brunswick Maine 04011 (US); Gross, Fritz A., Weston Maine 02193 (US)
(74) Representative: Jackson, David Spence

(56) References cited:
- EP-A- 0 097 565
- GB-A- 1 467 000
- GB-A- 2 105 942
- US-A- 2 942 257
- US-A- 4 145 692
- MICROWAVE JOURNAL, vol. 30, no. 1, January 1987, Norwood, MA, US; D.R. LOHRMANN: "A useful tool for developing, testing, maintaining or calibrating mm-wave seeker radars"

## Description

This invention relates to a radar performance monitor comprising:
means for receiving a radar signal from a radar system;
means coupled to the receiving means for converting a received radar signal into an intermediate frequency signal;
means for generating a plurality of simulated radar target return signals;
means for actuating the generating means in response to the intermediate frequency signal exceeding a predetermined amplitude; and
means coupled to the generating means for transmitting the simulated target return signals to the radar system for display on display means thereof.

Such a radar performance monitor is described in U.S. Patent No. 4,145,692 to David G. Armstrong et al and assigned to the present assgnee. As stated therein it is generally not difficult to determine whether a landbased radar is operating properly or not; there are small fixed targets whose appearance on the display is known and remembered, and if they fade or disappear, the radar is losing sensitivity or malfunctioning. Marine radars, on the other hand, are generally used far out at sea where there may normally be no targets and a partial or complete loss of radar performance may not be apparent to the operator. Some countries require by law that the marine radars be equipped with some sort of performance monitor and this requirement will become more prevalent. Such monitors are particularly useful with the kind of radar which performs automatic tracking and can operate in a night watch mode in which it is unattended by an operator. If the radar detects and tracks an object which may be on a collision course, an alarm is sounded. The alarm is also sounded if the performance monitor detects a radar malfunction alerting the operator that automatic tracking is not being reliably provided.

An echo box has been used in the past for monitoring radar performance; this has been generally expensive and not very satisfactory. It usually requires direct coupling into the radar's RF transmission line. It is limited in the range at which it can produce a response on the radar's display. It commonly requires a mechanical, motor-driven, tuning device.

The monitor described in U.S. Patent No. 4,145,692 not only provided a test pattern for monitoring the radar's transmitted power level and receiver sensitivity but also indicated the proper tuning of the receiver to the transmitter frequency, and therefore, was used as an aid in tuning a manually tunable radar receiver.
However, that performance monitor had a local oscillator controlled by an AFC loop which was complicated and required many parts resulting in relatively high costs and low reliability as compared with the performance monitor of the present invention.

GB-A-2 105 942 describes a radar performance monitor which is coupled to the transmitter trigger pulse generator and the local oscillator in the system to be monitored. The monitor has an antenna fixed to the structure of the system transmit/receive antenna, a mixer coupled to the radar system local oscillator and to the monitor antenna for converting a received radar signal into an intermediate frequency signal, a feedback loop including a delay line for generating a plurality of simulated radar target return intermediate frequency signals of diminishing amplitude that are up converted by passing through the mixer to the monitor antenna, and a frequency shifter for simulating a Doppler shift in the simulated radar target return intermediate frequency signals. The feedback loop circuitry and the frequency shifter are brought into operation as required by the radar system operator by the operation of a switch in a high tension supply to those elements of the monitor.

EP-A-0 097 565 describes a circuit for generating delayed bursts of a frequency, with variable amplitude of the bursts. The circuit has input and output couplers connected by a delay line and a variable gain amplifier in series. There is also a direct connection between the couplers so that a complete loop is formed.

According to the present invention, a radar performance monitor as defined hereinbefore at the beginning is characterised in that the generating means includes a recirculating loop, and the actuating means is arranged to gate the intermediate frequency signal into the recirculating loop when the intermediate frequency signal exceeds a predetermined amplitude.

In a preferred embodiment of the present invention a radar performance monitor (RPM) has a recirculating delay line and is mounted near an antenna of a radar system for determining the performance of the radar system. In addition, a method is provided for determining the performance of a radar system, as defined in claim 12. The radar performance monitor in the preferred embodiment is a low power transponder that is controlled remotely by a radar operator to test for degradation of the radar system transmitter power and receiver sensitivity. The RPM transmits a series of simulated radar target return signals of known amplitude if the incoming signal from the radar system is of the correct power level and frequency. The RF output of the RPM may be used to tune the radar system in the absence of natural targets.

In a preferred embodiment of the present invention, the radar performance monitor is provided with a recirculating loop comprising delay line means for generating the plurality of simulated radar target return signals.

The delay line means in the recirculating loop comprises a surface acoustical waveguide (SAW) delay line. A power divider coupled to a power splitter provides for coupling the plurality of simulated radar target return signals from the recirculating loop to the transmitting means. The plurality of simulated radar target return signals provide a distinct test pattern on the display means of the radar system simultaneously with normal radar target returns and the test pattern comprises a series of arcs having a predetermined width and separation in range and extending from a first to a second predetermined range limit on the display means with the azimuth width of the pattern being determined by a radiation pattern of the radar antenna.

Preferably, for calibrating the monitoring of the power output of a transmitter of a radar system, the following steps are carried out: receiving a radar signal in the radar performance monitor transmitted by the radar system, generating a plurality of simulated radar target return signals in the radar performance monitor in response to the received radar signal, switching a fixed attenuating means in series with the received radar signal, adjusting a detector means for the received radar signal such that the simulated radar target return signals are barely generated or visible on a display of the radar system, and removing the attenuating means and observing the simulated radar target return signals on the display of the radar system, the transmitter having acceptable output power when the return signals are visible on the display means.

Preferably, also, for calibrating the monitoring of sensitivity of a receiver of a radar system, the following steps are carried out: generating a plurality of simulated radar target return signals in the radar performance monitor, monitoring the return signals on a display means of the radar system, switching a fixed attenuating means in series with the generated plurality of simulated radar return signals, transmitting the plurality of simulated radar target return signals to the antenna of the radar system, adjusting the return signals monitored on the display means of the radar system to be barely visible when the attenuating means is switched in series, and removing the attenuating means and observing the return signals on the display, the receiver having acceptable sensivitity to signals at the frequency of a transmitter of the radar system when the return signals are visible on the display means.

### Brief Description of the Drawings

Other and further features of the invention will become apparent in connection with the accompanying drawings wherein:
FIG. 1 is a block diagram of a radar system and the radar performance monitor of the invention for use with the radar system;
FIG. 2 is a detailed block diagram of the radar performance monitor of the invention;
FIG. 3A is a block diagram of an X-BAND frequency converter within the radar performance monitor;
FIG. 3B is a block diagram of an S-BAND frequency converter within the radar performance monitor;
FIG. 4 is a timing diagram of the radar performance monitor response signals;
FIG. 5 shows a response pattern of a radar performance monitor on a radar system display;
FIG. 6 is a schematic diagram of the multiplexer shown in FIG. 2;
FIG. 7 is a block diagram of the multiplexer control shown in FIG. 2; and
FIG. 8 is a schematic diagram of the voltage variable attenuator shown in FIG. 2.

### Description of the Preferred Embodiment

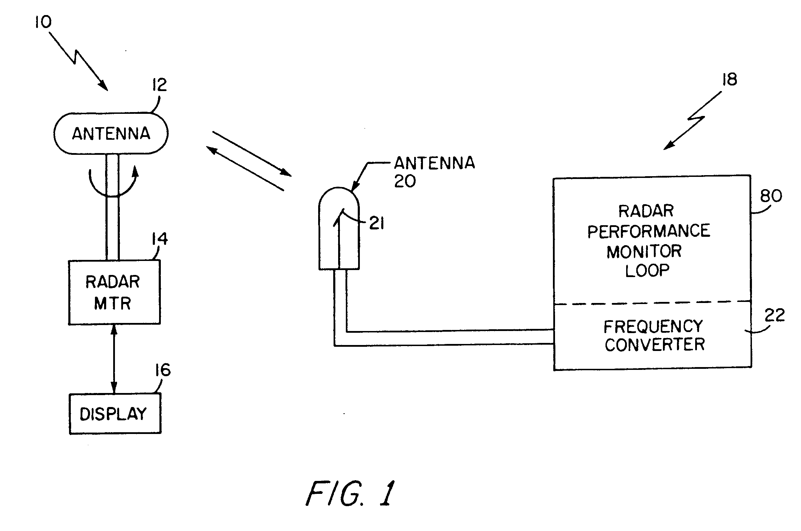

Referring now to FIG. 1 there is shown a block diagram of a radar system 10 used in connection with a radar performance monitor (RPM) 18 of the present invention. The radar system comprises an antenna 12, a modulator-transmitter-receiver (MTR) 14 and a display 16. The antenna 12 is in practice mounted as high as possible with an unobstructed path for the antenna beam to maximize the range of the antenna 12. The radar MTR 14 is located in a weather-tight position as close as is practical to the antenna 12 to minimize losses in the high-power transmit pulses coupled to antenna 12 and the low-level receive signals coupled from antenna 12. The display 16 coupled to MTR 14 provides for the display of radar information and includes operating controls of the radar system 10 and control of the radar performance monitor 18.

A basic block diagram of the radar performance monitor (RPM) 18 is also shown in FIG. 1 adjacent to the radar system 10. The RPM 18 comprises an antenna 20 coupled to a frequency converter 22 which is coupled to an RPM loop 80. The RPM 18 is a low power transponder that is controlled by a radar operator located at the display 16 of radar system 10. The RPM 18 tests for degradation of the radar transmitter power and of the radar receiver sensitivity to signals of the radar transmitter frequency. The RPM 18 transmits a train of simulated targets of known amplitude if the incoming signal from the radar system 10 is of the correct power level and frequency. The radio frequency (RF) output of the RPM 18 from antenna 20 is used to tune the radar receiver of the MTR 14 particularly in the absence of natural targets such as in shipboard applications far at sea. Distinct arcs within a wedge shaped area appear on the radar system display 16 when the radar receiver of the MTR 14 is sufficiently sensitive and properly tuned. The RPM 18 is generally attached directly to the support structure of the rotary radar antenna 12 just below the antenna. The frequency converter 22 may comprise a local oscillator operating in X-Band at 9590 MHz or a local oscillator operating in S-Band at 3230 MHz.

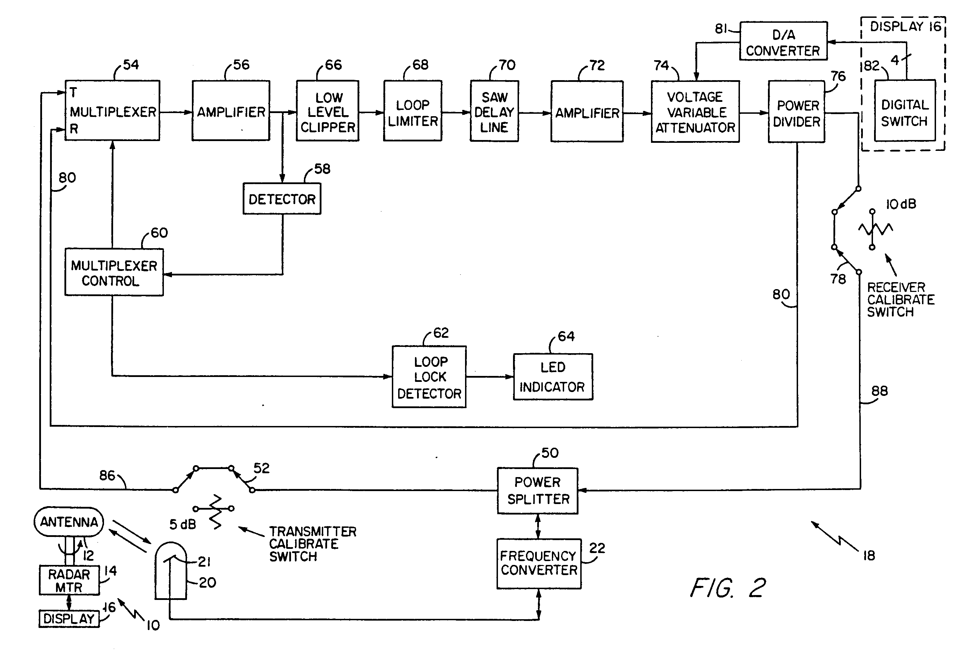

Referring now to FIG. 2, there is shown a detailed block diagram of the RPM 18. Radar antenna 12 transmits a series of pulses into space. Antenna 20 receives a sample of the transmitted pulses which may be at X-Band or at S-Band. For the present embodiment, the transmitted pulses are in the X-Band at 9410 MHz. Antenna 20 comprising a microwave patch 21 couples the received pulses to an input of the X-Band frequency converter 22.

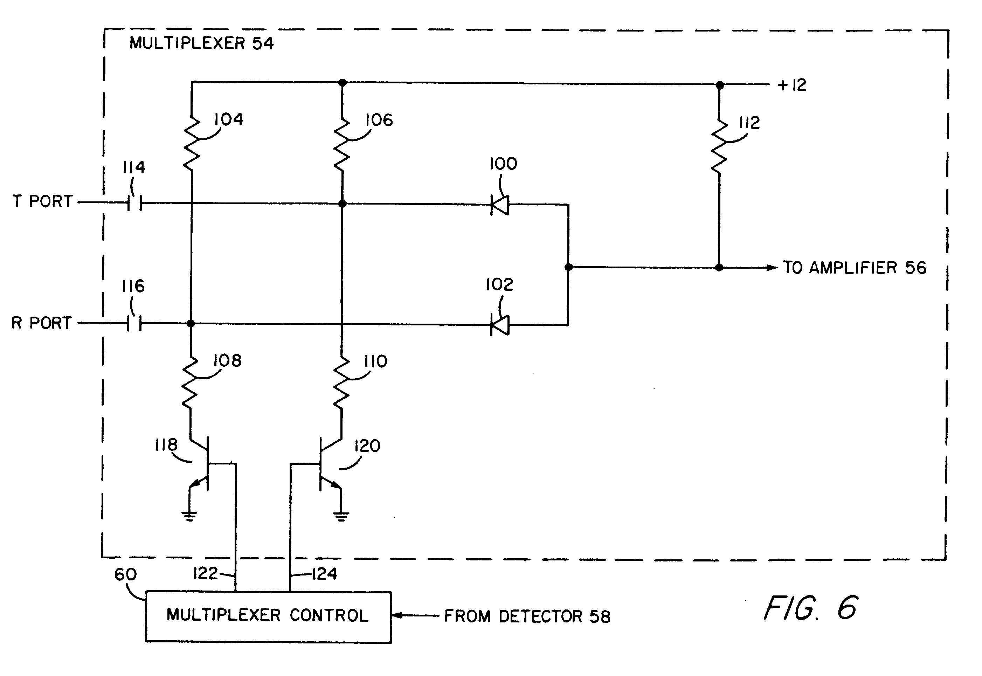

The X-Band frequency converter 22 down-converts the incoming 9410 MHz signal to a 180 MHz intermediate frequency (IF) signal which is coupled to a power splitter 50. The power splitter 50 is a two way in-phase power splitter combiner which may be embodied by Model PSE-2-1 manufactured by Minicircuits of Brooklyn, New York. The IF signal passes through the power splitter 50 (which also passes an output signal from a power divider 76 back to the microwave patch antenna 20) and couples the IF signal to a recirculating loop 80 via a T-port of multiplexer 54. A small portion of the IF signal from the second output of power splitter 50 is coupled to power divider 76 but is essentially attenuated and does not affect the RPM 18 operation. Referring now to FIG. 6, the multiplexer 54 comprises two DC controlled pin diodes (100, 102) which act as variable resistors. Initially pin diode 100 is on (transistor 120 saturated) and pin diode 102 is off (transistor 118 cutoff). Pin diode 100 feeds the transmitter sample into the loop. Resistors 104, 106, 108 and 110 provide isolation of the RF path from the DC path as well as bias current control. When the transmitter sample has been introduced into the loop, the multiplexer control 60 switches diode 100 off (transistor 120 cutoff) and diode 102 on (transistor 118 saturated) to permit continuous circulation. The pin diodes 100 and 102 typically offer 35 dB of isolation when biased off.

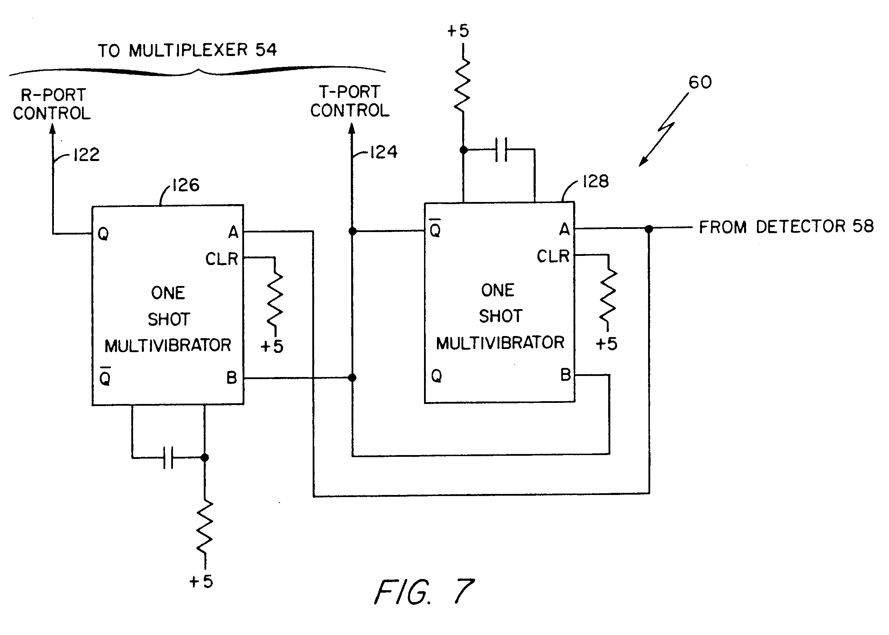

Referring now to FIG. 2 and FIG. 7, the IF signal entering the recirculating loop 80 is amplified and detected by amplifier 56 and detector 58. The detector 58 converts the RF signal into a DC voltage and comprises an adjustable resistor for setting the point at which the loop 80 turns on which typically occurs at -10 dBm. The detector 58 output is coupled to multiplexer control 60 which comprises dual one-shot multivibrators as shown in FIG. 7. The detector output triggers one-shot multivibrators 126 and 128 in multiplexer control 60 which enables or gates on the R-port of the multiplexer 54 for 75 microseconds and disables or inhibits the T-port for approximately 340 microseconds.
The one-shot multivibrator 128 controlling the T-port has a longer time constant or period than the one-shot multivibrator 126 to insure that the recirculating loop 80 has been off for some time before the T-port is enabled again. This timing insures that the simulated radar target return signals or pulses delayed by SAW delay line 70 are not prematurely entered into the T-port of multiplexer 54 setting the RMP 18 into oscillation. The one-shot multivibrators 126, 128 may be embodied by Model 74221 dual monostable multivibrators as manufactured by Texas Instruments of Dallas, Texas. The recirculating loop 80 is constructed so that the loop gain is greater than unity and incorporates limiting to maintain constant pulse amplitude.

Still referring to FIG. 2, the IF signal after passing through amplifier 56 is coupled to a low level clipper 66 which separates the signal from the noise and eliminates noise build-up by passing only signals above a certain amplitude. When the IF signal is below +13 dBm, there will be considerable attenuation. If the RF input signal exceeds +13 dBm, there is little attentuation. The low level clipper 66 comprises two back-to-back Schottky diodes in series with the incoming signal with a matching resistor on either side of the clipper, such design being readily known to one skilled in the art. The RF signal is then coupled to a loop limiter 68 which sets the maximum limiter output level to 3 dBm. This limits the signal dynamic range to 10-12 dB which is the ratio of the limit level to clipping level.

The signal from loop limiter 68 is then coupled to a wideband surface acoustical waveguide (SAW) delay line 70 which in conjunction with a loop 80 generates a series of similated radar target returns under the control of the multiplexer control 60. The number of target returns generated is determined by the length of time that the multiplexer control 60 enables the R-port of multiplexer 54. The SAW delay line 70 may be embodied by model number CTI-160 as manufactured by Crystal Technology of Palo Alto, CA having a 4 microsecond delay, a centre frequency of 180 MHz, a bandwidth of 80 MHz and an insertion loss of 28 dB. The signals delayed by the SAW delay line 70 are coupled to an amplifier 72 which makes up for the loss of the SAW delay line 70 and furnishes an input signal to a voltage variable attenuator 74. The multiplexer control 60 determines how many pulses pass through the SAW delay line 70. As described hereinbefore the one-shot multivibrator 126 in multiplier control 60 enables the R-port for 75 microseconds which provides for approximately 18 pulses (75 ÷ 4 microseconds SAW delay) to pass through the loop.

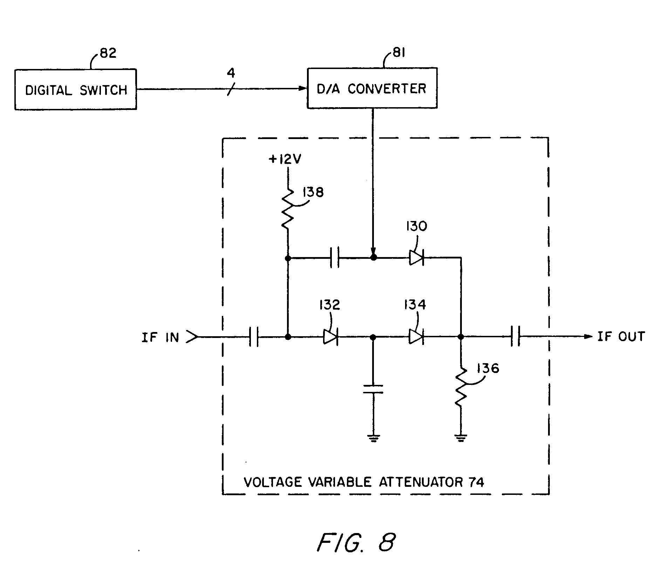

The voltage variable attenuator 74 controls the amount of power output from the RPM 18 and as shown in FIG. 8 comprises a constant impedance current controlled attenuator comprising three pin diodes 130, 132 and 134. The voltage variable attenuator 74 is adjusted by a four bit digital switch 82 which produces a voltage output from the D/A converter 81. The variable current (0.075 ma to 6 ma) through pin diode 130 and resistor 136 gives approximately 0 to 15 dB of attenuation to the IF signal.

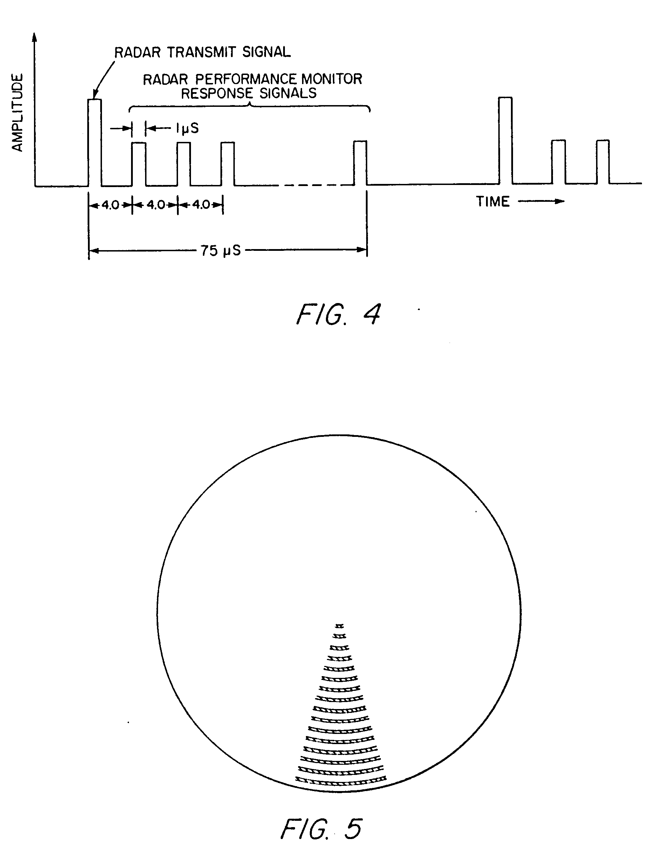

Referring now to FIGS. 2, 4, and 5 the IF signal after passing through the voltage variable attenuator 74 is coupled to a power divider 76 which provides a portion of the output from the recirculating loop 80 to power splitter 50; the IF signal is upconverted to the original radar signal frequency by mixing the 180 MHz IF with the X-Band local oscillator signal in the frequency converter 22 for transmission via the antennas 20 and 12 to a radar receiver (MTR 14) in radar system 10 where it appears as a target on a display 16 at multiples of 536m (1/3 of a mile). The recirculating loop 80 of RPM 18 continues to generate response signals or targets as shown in FIG. 4 until a one-shot in the multiplexer control 60 turns off the feedback input (R-port) of multiplexer 54. The transmitter input (T-port) is enabled 265 microseconds later and the response signal generating cycle repeats upon receipt of a next transmit pulse. FIG. 5 shows a display screen of radar display 16 which is displaying a wedge-shaped pattern generated by the response signals from the RPM 18. The loop lock detector 62 receiving an input from the multiplexer control 60 and having an output coupled to a light emitting diode (LED) indicator 64 provides a means of indicating that the RPM 18 is operating properly without the need for sophisticated test equipment. The timing is implemented such that the loop 80 has to be circulating for a full 75 microseconds before the LED indicator 64 is turned on.

Still referring to FIG. 2, a transmitter calibrate switch 52 is shown coupled between the power splitter 50 and multiplexer 54. The transmitter calibrate switch 52 provides for calibration of the radar system 10 transmitter in the MTR 14 by manually switching a 5 dB pad into the IF input line 86. With the 5 dB pad inserted, detector 58 is adjusted so that the RPM 18 is marginally operational, and then the 5 dB pad is switched out. When the 5 dB pad is switched out and if the transmitter power of radar system 10 drops by more than 5 dB during normal operation, the RPM 18 will cease to operate which is immediately detected by an operator at the display 16 of radar system 10.

A receiver calibrate switch 78 is shown coupled between the power divider 76 and power splitter 50 in line 88. The receiver calibrate switch 78 provides for calibration of the receiver in the MTR 14 of radar system 10 by remotely switching a 10 dB pad into the output line 88 from power divider 76 at the recirculating loop 80 output in RPM 18. When the 10 dB pad is switched in, the output signal from the RPM 18 is reduced by 10 dB. The voltage variable attenuator 74 is adjusted by means of digital switch 82 located at the display 16 to make the output signals of the RPM 18 on the display 16 of radar system 10 just barely visible. When the receiver calibrate switch 78 is returned to the operate position, the output level of the RPM 18 increases by 10 dB. The radar system 10 is now calibrated whereby a drop of 10 dB in receiver sensitivity in the radar MTR 14 causes the RPM 18 output signal being displayed on display 16 to disappear indicating a failure condition. A partial failure is indicated by the narrowing of the RPM 18 output signal arcs on display 16.

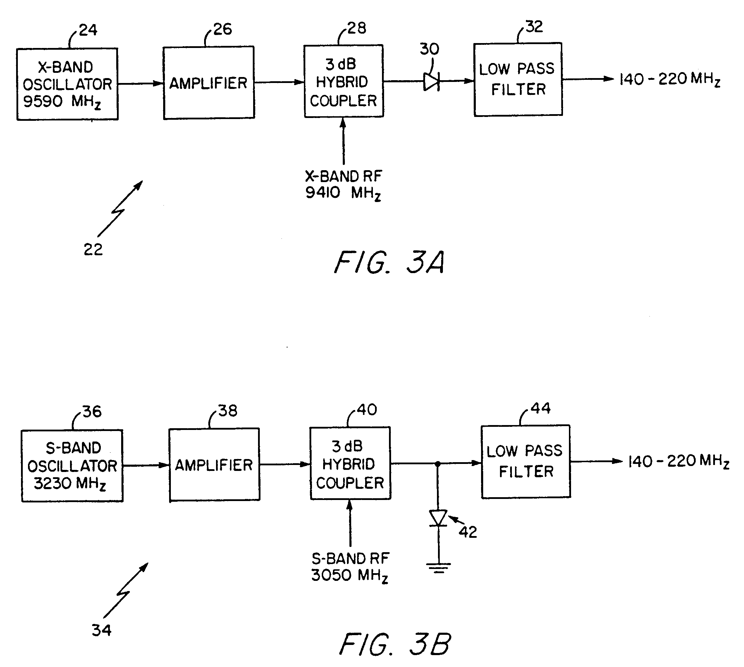

Referring now to FIG. 3A, there is shown a block diagram of the X-Band frequency converter 22 comprising an X-Band local oscillator 24 which is tunable from 9450 to 9650 MHz and has an output power level of +11 dBm. The total frequency variation over a temperature range of 0°C to 100°C is ±12.5 MHz. Since the total range of frequency variation of the radar transmitter is ±25 MHz (including magnetron manufacturer's tolerances, change of frequency during warm-up, and steady-state variation with ambient temperature) and since the bandwidth of the recirculating loop and other IF components (determined by the bandwidth of the delay line) is 80 MHz, the stability of the local oscillator frequency with changes in ambient temperature is adequate and no heater or other means of limiting the range of temperature for the local oscillator is required. The output of the X-Band local oscillator 24 is coupled to amplifier 26 which provides 2 dB of gain. Amplifier 26, readily known to one skilled in the art, comprises two identical stages (not shown) each consisting of a chip attenuator followed by an FET amplifier. Variations in gain are achieved by the chip attenuators. The amplifier 26 is used as a buffer to prevent pulling of the X-Band oscillator 24. The amplifier 26 output is coupled to a 3 dB hybrid coupler 28 which receives at another input the X-Band RF 9410 MHz signal from antenna 20 and provides isolation between the RF signal and the local oscillator signal while combining them at the expense of 3 dB loss. The outputs of the 3 dB hybrid coupler 28 are coupled to a mixer diode 30 and the resulting IF signal is coupled to a low pass filter 32 which reflects the RF signal and the oscillator signal back to the diode. The low pass filter has a 6000 MHz cutoff and provides greater than 30 dB rejection of the RF and local oscillator X-Band signals. The IF signal generated at the input of the low pass filter 32 is nominally 180 MHz.

Referring now to FIG. 3B, an alternative RF section or frequency converter 34 is shown having an S-Band oscillator 36 producing a 3230 MHz signal at an output power level of approximately +9 dBm. The frequency variation from 0°C to 100°C is 3 MHz which is better stability than at X-Band and hence quite adequate. The 3230 MHz signal is coupled to an amplifier 38 which isolates the local oscillator 36 from impedance changes and increases the 3230 MHz oscillator signal level to +18 dBm. The amplifier 38 output is coupled to a 3 dB hybrid coupler 40 which receives at another input the S-Band RF 3050 MHz signal from antenna 20 and provides isolation between the RF signal and the local oscillator while combining them at the expense of 3 dB loss. The outputs of the 3 dB hybrid coupler 40 are coupled to a single diode mixer 42 and a low pass filter 44. The diode mixer 42 mixes the RF signal and local oscillator signal and produces an IF output signal at a nominal 180 MHz.

The low pass filter 44 has a 2300 MHz cutoff to provide rejection of the RF and oscillator signals and to pass the 180 MHz IF signal.

## Claims

1. A radar performance monitor comprising:
means (21) for receiving a radar signal from a radar system (10);
means (22) coupled to the receiving means (21) for converting a received radar signal into an intermediate frequency signal;
means (80,50,22) for generating a plurality of simulated radar target return signals;
means (54,58,60) for actuating the generating means (80,50,22) in response to the intermediate frequency signal exceeding a predetermined amplitude; and
means (21) coupled to the generating means (80,50,22) for transmitting the simulated target return signals to the said radar system (10) for display on display means (16) thereof, characterised in that the generating means includes a recirculating loop (80), and the actuating means (54,58,60) is arranged to gate the intermediate frequency signal into the recirculating loop (80) when the intermediate frequency signal exceeds the predetermined amplitude.

2. A radar performance monitor according to claim 1,
characterised in that the recirculating loop (80) includes delay line means (70).

3. A radar performance monitor according to claim 2,
characterised in that the delay line means comprises a surface acoustical waveguide delay line (70).

4. A radar performance monitor according to claim 1,characterised in that
a power divider means (76) is arranged to couple a plurality of intermediate frequency signals from the recirculating loop (80) to the transmitting means (21).

5. A radar performance monitor according to claim 1, characterised in that
the generating means includes power splitting means (50) coupled to the converting means (22) for coupling the intermediate signal to and from a recirculating loop (80);
means (54,58) coupled to the power splitting means (50) for gating and detecting the intermediate frequency signal above a predetermined threshold;
means (60) coupled to the gating and detecting means (54,58) for controlling the number of simulated radar target return signals generated by the generating means (80);
means (68) coupled to the gating and detecting means (54,58) for limiting the dynamic range of the intermediate frequency signal;
variable attenuator means (74) coupled to the limiting means (68) for adjusting the power output of the generated return signals;
power divider means (76) coupled to the variable attenuator means (74) for providing an output for a plurality of intermediate frequency signals from the recirculating loop (80), the intermediate frequency signals being coupled to the power splitting means (50).

6. A radar performance monitor according to claim 5,
characterised in that the recirculating loop (80) includes an amplifier means (72) for supplying predetermined signal levels to the variable attenuator means (74).

7. A radar performance monitor according to claim 5, characterised by
means (16,81,82) for a radar operator to remotely adjust the variable attenuator means (74).

8. A radar performance monitor according to claim 5, charcterised by
a switchable attenuating means (52) coupled between the power splitting means (50) and the recirculating loop (80) to provide for calibration of a transmitter of a radar system (10).

9. A radar performance monitor according to claim 5, characterised by
a switchable attenuating means (78) coupled between the power divider means (76) and the power splitting means (50) to provide for calibration of a receiver of a radar system (10).

10. A radar performance monitor according to claim 5,
characterised in that the controlling means (60) comprises timing means (126,128) for turning on the recirculating loop (80) while inhibiting a subsequent intermediate frequency signal from entering the loop (80) for a first predetermined time period, and turning off the recirculating loop (80) for a second predetermined time period before allowing a subsequent intermediate frequency signal to enter the recirculating loop (80).

11. A radar perforance monitor according to claim 1,
characterised by means (52) coupled between the converting means (22) and the actuating means (54,58,60) for calibrating a power level of a transmitter output of a radar system (10).

12. A method of determining the performance of a radar system, comprising the steps of:
receiving (21) a radar signal transmitted by the system (10);
converting (22) the received radar signal to an intermediate frequency signal;
generating a plurality of simulated radar target return signals when the intermediate frequency signal exceeds a predetermined amplitude;
transmitting (21) the plurality of simulated radar target return signals to the radar system (10); and
displaying the simulated radar target return signals on a display means (16) of the radar system (10), characterised in that the step of generating the return signals includes gating the intermediate frequency signal into a recirculating loop (80) when the intermediate frequency signal exceeds the predetermined amplitude.

13. A method according to claim 12, characterised in that the step of generating the plurality of simulated radar target return signals includes coupling a plurality of intermediate frequency signals through a power divider means (76) from the recirculating loop (80) to transmitting means (21).

## Patentansprüche

1. Radar-Betriebsüberwachungseinrichtung, enthaltend:
Mittel (21) zum Empfang eines Radarsignales von einem Radarsystem (10);
Mittel (22), die mit den Empfangsmitteln (21) gekoppelt sind, um ein empfangenes Radarsignal in ein Zwischenfrequenzsignal umzuformen;
Mittel (80, 50, 22) zur Erzeugung einer Mehrzahl von simulierten Radar-Zielobjektechosignalen;
Mittel (54, 58, 60) zu Betätigung der die simulierten Signale erzeugenden Mittel (80, 50, 22) in Abhängigkeit von dem Zwischenfrequenzsignal, welches eine vorbestimmte Amplitude übersteigt; und
Mittel (21), die mit den die simulierten Signale erzeugenden Mitteln (80, 50, 22) verbunden sind, um die simulierten Zielobjekt-Echosignale zur dem Radarsystem (10) für die Anzeige auf dessen Anzeigemitteln (16) zu übertragen,
dadurch gekennzeichnet, daß die die simulierten Signale erzeugenden Mittel eine Umlaufschleife (80) enthalten und daß die Betätigungsmittel (54, 58, 60) so ausgebildet sind, daß sie das Zwischenfrequenzsignal in die Umlaufschleife (80) hineinschalten, wenn das Zwischenfrequenzsignal die vorbestimmte Amplitude übersteigt.

2. Radar-Betriebsüberwachungseinrichtung nach Anspruch 1, dadurch gekennzeichnet, daß die Umlaufschleife (80) Verzögerungsleitungsmittel (70) enthält.

3. Radar-Betriebsüberwachungseinrichtung nach Anspruch 2, dadurch gekennzeichnet, daß die Verzögerungsleitungsmittel eine akustische Oberflächenwellen-Verzögerungsleitung (70) enthalten.

4. Radar-Betriebsüberwachungseinrichtung nach Anspruch 1, dadurch gekennzeichnet, daß Leistungsteilermittel (76) vorgesehen sind, um eine Mehrzahl von Zwischenfrequenzsignalen von der Umlaufschleife (80) zu den Übertragungsmitteln (21) zu koppeln.

5. Radar-Betriebsüberwachungseinrichtung nach Anspruch 1, dadurch gekennzeichnet, daß die die simulierten Signale erzeugenden Mittel Leistungsaufteilungsmittel (50) enthalten, die mit den Umformungsmitteln (22) gekoppelt sind, um das Zwischenfrequenzsignal zu einer Umlaufschleife (80) hin und von dieser weg zu koppeln, daß mit den Leistungsaufteilungsmitteln (50) Torschaltmittel und Detektormittel (54, 58) zur Torschaltung und Detektierung des Zwischenfrequenzsignales oberhalb eines vorbestimmten Schwellwertes gekoppelt sind, daß mit den Torschaltmitteln und Detektormitteln (54, 58) Steuermittel zur Steuerung der Zahl der simulierten Radar-Zielobjekts-Echosignale verbunden sind, die von den Erzeugungsmitteln (80) erzeugt werden, daß mit den Torschalt- und Detektormitteln (54, 58) Begrenzungsmittel (68) zur Begrenzung des dynamischen Bereiches des Zwischenfrequenzsignales gekoppelt sind, daß veränderbare Dämpfungsmittel (74) mit den Begrenzungsmitteln (68) verbunden sind, um den Leistungsausgang der erzeugten Echosignale einzustellen, und daß Leistungsteilermittel (76) mit den veränderbaren Dämpfungsmitteln (74) verbunden sind, um einen Ausgang für eine Mehrzahl von Zwischenfrequenzsignalen von der Umlaufschleife (80) zu liefern, wobei die Zwischenfrequenzsignale zu den Leistungsaufteilungsmitteln (50) gegeben werden.

6. Radar-Betriebsüberwachungseinrichtung nach Anspruch 5, dadurch gekennzeichnet, daß die Umlaufschleife (80) einen Verstärker (72) enthält, um vorbestimmte Signalpegel zu den veränderbaren Dämpfungsmitteln (74) zu liefern.

7. Radar-Betriebsüberwachungseinrichtung nach Anspruch 5, gekennzeichnet durch Mittel (16, 81, 82) für eine Radar-Bedienungsperson zur Ferneinstellung der veränderbaren Dämpfungsmittel (74).

8. Radar-Betriebsüberwachungseinrichtung nach Anspruch 5, gekennzeichnet durch schaltbare Dämpfungsmittel (52), die zwischen die Leistungsaufteilungsmittel (50) und die Umlaufschleife (80) geschaltet sind, um eine Eichung eines Senders eines Radarsystems (10) zu ermöglichen.

9. Radar-Betriebsüberwachungseinrichtung nach Anspruch 5, gekennzeichnet durch schaltbare Dämpfungsmittel (78), die zwischen die Leistungsteilermittel (76) und die Leistungsaufteilungsmittel (50) geschaltet sind, um eine Eichung eines Empfängers eines Radarsystems (10) zu ermöglichen.

10. Radar-Betriebsüberwachungseinrichtung nach Anspruch 5, dadurch gekennzeichnet, daß die Steuermittel (60) Zeitgebermittel (126, 128) enthalten, um die Umlaufschleife (80) während einer ersten vorbestimmten Zeitdauer einzuschalten, während ein nachfolgendes Zwischenfrequenzsignal daran gehindert wird, in die Schleife (80) einzutreten, und um die Umlaufschleife (80) für eine zweite vorbestimmte Zeitdauer auszuschalten, bevor ein nachfolgendes Zwischenfrequenzsignal in die Umlaufschleife (80) eintreten darf.

11. Radar-Betriebsüberwachungseinrichtung nach Anspruch 1, gekennzeichnet durch Eichmittel (52), die zwischen die Umformungsmittel (22) und die Betätigungsmittel (54, 58, 60) gelegt sind, um einen Leistungspegel eines Senderausgangs eines Radarsystems (10) zu eichen.

12. Verfahren zur Bestimmung der Betriebseigenschaft eines Radarsystems, mit folgenden Schritten:
Empfangen (21) eines von dem System (10) ausgesendeten Radarsignales;
Umformen (22) des empfangenen Radarsignales in ein Zwischenfrequenzsignal;
Erzeugen einer Mehrzahl simulierter Radar-Zielobjektechosignale, wenn das Zwischenfrequenzsignal eine vorbestimmte Amplitude übersteigt;
Übertragen (21) der Mehrzahl von simulierten Radarzielobjektechosignalen zu dem Radarsystem (10); und
Anzeigen der simulierten Radar-Zielobjektechosignale auf einem Wiedergabegerät (16) des Radarsystems (10), dadurch gekennzeichnet, daß der Schritt der Erzeugung der Echosignale das Torschalten des Zwischenfrequenzsignales in eine Umlaufschleife (80) hinein umfaßt, wenn das Zwischenfrequenzsignal die vorbestimmte Amplitude übersteigt.

13. Verfahren nach Anspruch 12, dadurch gekennzeichnet, daß der Schritt der Erzeugung der Mehrzahl simulierter Radar-Zielobjektechosignale das Koppeln einer Mehrzahl von Zwischenfrequenzsignalen durch Leistungsteilermittel (76) von der Umlaufschleife (80) zu Übertragungsmitteln (21) umfaßt.

## Revendications

1. Dispositif de contrôle de la performance d'un radar comprenant:
un moyen (21) pour recevoir un signal radar provenant d'un système radar (10);
un moyen (22) couplé au moyen de réception (21) pour convertir un signal radar reçu en un signal de fréquence intermédiaire;
un moyen (80,50,22) pour générer une pluralité de signaux réfléchis d'une cible radar simulée;
un moyen (54,58,60) pour actionner le moyen de génération (80,50,22) en réponse au dépassement par le signal de fréquence intermédiaire d'une amplitude prédéterminée; et
un moyen (21) couplé au moyen de génération (80,50,22) pour transmettre les signaux réfléchis de la cible simulée audit système radar (10) pour l'affichage sur un moyen d'affichage (16) de celui-ci, caractérisé en ce que le moyen de génération comporte une boucle de recyclage (80), et le moyen d'actionnement (54,58,60) est disposé pour sélectionner par porte le signal de fréquence intermédiaire dans la boucle de recyclage (80) quand le signal de fréquence intermédiaire dépasse l'amplitude prédéterminée.

2. Dispositif de contrôle de la performance d'un radar selon la revendication 1, caractérisé en ce que la boucle de recyclage (80) comporte un moyen de ligne à retard (70).

3. Dispositif de contrôle de la performance d'un radar selon la revendication 2, caractérisé en ce que le moyen de ligne à retard comprend une ligne à retard à guide d'onde acoustique de surface (70).

4. Dispositif de contrôle de la performance d'un radar selon la revendication 1, caractérisé en ce que
un moyen diviseur de puissance (76) est disposé pour coupler une pluralité de signaux de fréquence intermédiaire provenant de la boucle de recyclage (80) au moyen de transmission (21).

5. Dispositif de contrôle de la performance d'un radar selon la revendication 1, caractérisé en ce que
le moyen de génération comporte un moyen répartiteur de puissance (50) couplé au moyen de conversion (22) pour coupler le signal intermédiaire vers et depuis une boucle de recyclage (80);
un moyen (54,58) couplé au moyen répartiteur de puissance (50) pour sélectionner par porte et détecter le signal de fréquence intermédiaire au-dessus d'un seuil prédéterminé;
un moyen (60) couplé au moyen de sélection par porte et de détection (54,58) pour commander le nombre de signaux réfléchis de la cible radar simulée générés par le moyen de génération (80);
un moyen (68) couplé au moyen de sélection par porte et de détection (54,58) pour limiter la gamme dynamique du signal de fréquence intermédiaire;
un moyen d'atténuation variable (74) couplé au moyen limiteur (68) pour régler la sortie de puissance des signaux réfléchis générés;
un moyen diviseur de puissance (76) couplé au moyen d'atténuation variable (74) pour fournir une sortie pour une pluralité de signaux de fréquence intermédiaire provenant de la boucle de recyclage (80), les signaux de fréquence intermédiaire étant couplés au moyen répartiteur de puissance (50).

6. Dispositif de contrôle de la performance d'un radar selon la revendication 5, caractérisé en ce que la boucle de recyclage (80) comporte un moyen amplificateur (72) pour fournir les niveaux de signal prédéterminés au moyen d'atténuation variable (74).

7. Dispositif de contrôle de la performance d'un radar selon la revendication 5, caractérisé par
un moyen (16,81,82) permettant à un opérateur radar de régler à distance le moyen d'atténuation variable (74).

8. Dispositif de contrôle de la performance d'un radar selon la revendication 5, caractérisé par
un moyen d'atténuation commutable (52) couplé entre le moyen répartiteur de puissance (50) et la boucle de recyclage (80) pour fournir l'étalonnage d'un émetteur d'un système radar (10).

9. Dispositif de contrôle de la performance d'un radar selon la revendication 5, caractérisé par
un moyen d'atténuation commutable (78) couplé entre le moyen diviseur de puissance (76) et le moyen répartiteur de puissance (50) pour fournir l'étalonnage d'un récepteur d'un système radar (10).

10. Dispositif de contrôle de la performance d'un radar selon la revendication 5, caractérisé en ce que le moyen de commande (60) comprend un moyen de synchronisation (126,128) pour mettre sous tension la boucle de recyclage (80) tout en empêchant un signal de fréquence intermédiaire suivant d'entrer dans la boucle (80) pendant une première période de temps prédéterminée, et mettre hors tension la boucle de recyclage (80) pendant une seconde période de temps prédéterminée avant de permettre à un signal de fréquence intermédiaire suivant d'entrer dans la boucle de recyclage (80).

11. Dispositif de contrôle de la performance d'un radar selon la revendication 1, caractérisé par un moyen (52) couplé entre le moyen de conversion (22) et le moyen d'actionnement (54,58,60) pour étalonner un niveau de puissance d'une sortie d'émetteur d'un système radar (10).

12. Procédé de détermination de la performance d'un système radar, comprenant les étapes de:
réception (21) d'un signal radar émis par le système (10);
conversion (22) du signal radar reçu en un signal de fréquence intermédiaire;
génération d'une pluralité de signaux réfléchis de la cible radar simulée quand le signal de fréquence intermédiaire dépasse une amplitude prédéterminée;
transmission (21) de la pluralité de signaux réfléchis de la cible radar simulée vers le système radar (10); et
affichage des signaux réfléchis de la cible radar simulée sur un moyen d'affichage (16) du système radar (10), caractérisé en ce que l'étape de génération des signaux réfléchis comporte la sélection par porte du signal de fréquence intermédiaire dans une boucle de recyclage (80) quand le signal de fréquence intermédiaire dépasse l'amplitude prédéterminée.

13. Procédé selon la revendication 12, caractérisé en ce que l'étape de génération de la pluralité de signaux réfléchis de la cible radar simulée comporte le couplage d'une pluralité de signaux de fréquence intermédiaire par l'intermédiaire d'un moyen diviseur de puissance (76) depuis la boucle de recyclage (80) vers le moyen de transmission (21).
